# FASCICULE DE BREVET EUROPEEN

(11) **EP 0 815 456 B1**
(45) Date de publication et mention de la délivrance du brevet: **15.09.1999**
(21) Numéro de dépôt: 96905666.2
(22) Date de dépôt: 25.03.1996
(51) Int. Cl.: G01R 15/20, H01F 27/30, H05K 1/18

(54) **CAPTEUR DE COURANT ELECTRIQUE**
ELEKTRISCHER STROMSENSOR
ELECTRICAL CURRENT SENSOR

(30) Priorité: 24.03.1995 JP 9151095
(43) Date de publication de la demande: 07.01.1998
(73) Titulaire: LIAISONS ELECTRONIQUES-MECANIQUES LEM S.A., CH-1228 Plan-les-Ouates (CH)
(72) Inventeur: SAVARY, Pierre, Yodogawa-ku, Osaka 532 (JP); LAFORET, Marc, Yodogawa-ku, Osaka 532 (JP)
(74) Mandataire: Hranitzky, Wilhelm Max
(86) Numéro de dépôt international: CH9600109
(87) Numéro de publication internationale: WO9630773

(56) Documents cités:
- EP-A- 0 616 346
- CH-A- 669 079
- DE-A- 2 626 753
- GB-A- 2 219 864
- US-A- 4 893 073
- US-A- 4 939 449
- US-A- 4 939 623
- PATENT ABSTRACTS OF JAPAN vol. 017, no. 314 (P-1557), 15 Juin 1993 & JP,A,05 034375 (HYOGO NIPPON DENKI KK), 9 Février 1993,

## Description

La présente invention concerne un capteur de courant comportant un circuit magnétique avec un entrefer, un détecteur de champ magnétique disposé dans ledit entrefer et une plaque de support portant un circuit électrique agencé pour amplifier un signal de sortie dudit détecteur de champ magnétique, cette plaque de support présentant une zone découpée.

Un exemple d'un tel capteur est décrit dans le document GB 2 219 864 A. Les capteurs de ce type ne répondent cependant pas à toutes les exigences du point de vue encombrement et prix de revient.

La présente invention vise ainsi plus particulièrement à réduire l'encombrement d'un tel capteur ainsi que la place qu'il occupe lors de son montage sur un circuit extérieur, et elle a notamment pour but de réaliser un capteur de forme essentiellement plate. Un but essentiel de l'invention est dans ce contexte de permettre la fabrication du capteur en grande série de façon très économique et rationnelle. Un autre but de l'invention est de fournir un tel capteur de dimensions réduites présentant néanmoins une très faible influence du circuit dans lequel passe le courant à mesurer sur le circuit de mesure, et également une bonne immunité vis-à-vis de champs électromagnétiques extérieurs.

Le capteur selon l'invention est caractérisé en ce que, le circuit magnétique étant réalisé sous forme d'un empilement de tôles et portant un enroulement dans lequel passe le courant électrique à mesurer, un tube électriquement isolant est disposé autour d'une branche de ce circuit magnétique à l'intérieur dudit enroulement de façon à maintenir ensemble à cet endroit les parties des différentes tôles formant ladite branche, et une partie du circuit magnétique est fixée mécaniquement directement sur la plaque de support de façon à maintenir ensemble les tôles du circuit au moyen de cette fixation et de telle façon que ledit enroulement soit disposé au moins partiellement dans ladite zone découpée.

Selon une forme d'exécution du capteur, la plaque de support comporte au moins une zone métallisée de blindage reliée à la masse du circuit électrique, cette zone présentant au moins une partie s'étendant entre le détecteur de champ magnétique et ledit enroulement. Cette zone de blindage peut présenter une portion s'étendant entre la plaque de support et une partie du circuit magnétique. De préférence, une telle zone métallisée de blindage est prévue de chaque côté de la plaque de support.

Selon une forme d'exécution préférée, l'enroulement est disposé sur une branche essentiellement rectiligne du circuit magnétique, l'entrefer étant formé entre une partie de surface latérale d'une extrémité libre de cette branché rectiligne et une extrémité libre d'une branche du circuit magnétique perpendiculaire à ladite branche rectiligne.

Pour permettre l'utilisation d'un enroulement préformé et la mise en place d'un tel enroulement sur ladite branche rectiligne du circuit magnétique, l'épaisseur de l'enroulement dans le sens transversal de celui-ci est inférieure à la longueur de l'entrefer du circuit magnétique.

Le tube isolant disposé sur la branche du circuit magnétique portant l'enroulement peut avantageusement être réalisé en un matériau thermo-rétrécissable.

Par ces différentes mesures, l'invention permet de réaliser un capteur de courant atteignant les objectifs susmentionnés d'une manière optimale.

L'invention sera mieux comprise à la lumière de la description détaillée d'un exemple de réalisation illustré dans le dessin annexé, dans lequel:
la Fig. 1 est une vue latérale d'un capteur de courant selon l'invention;
la Fig. 2 est une vue latérale du même capteur du côté opposé à celui de la Fig. 1;
la Fig. 3 est une vue en coupe selon la ligne A-A de la Fig. 1;
la Fig. 4 est un schéma électrique simplifié d'un capteur de courant selon l'invention; et
la Fig. 5 est une vue frontale d'un circuit magnétique muni d'un enroulement, utilisable dans un capteur de courant selon la Fig. 1.

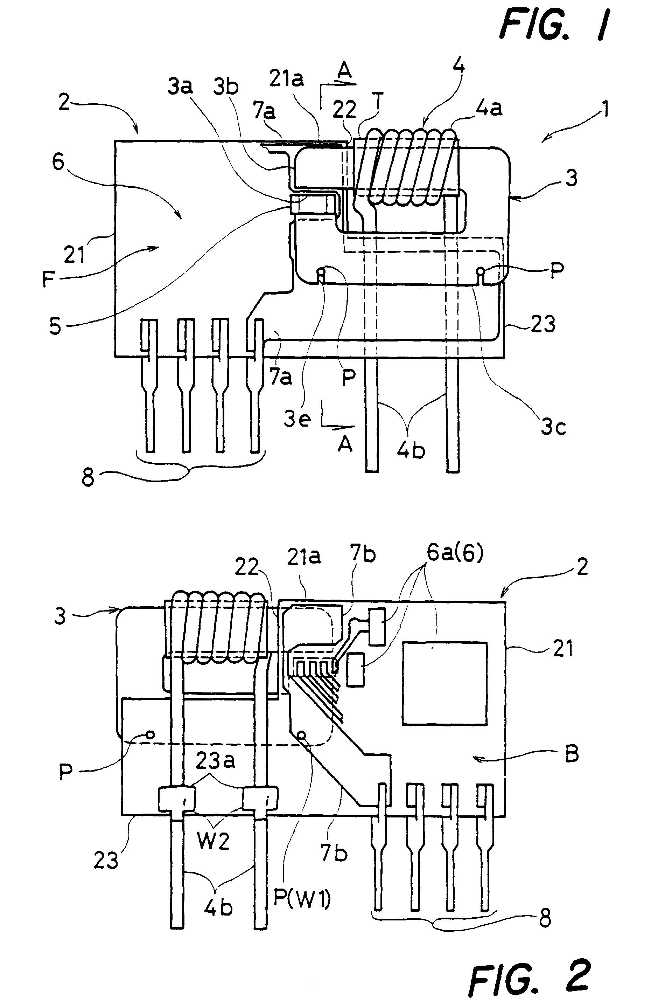

Le capteur de courant représenté aux Figs 1 et 2 comporte un circuit magnétique 3 présentant un entrefer 3a et portant un enroulement 4 dans lequel passe le courant à mesurer. Un élément détecteur de champ magnétique 5 est disposé à l'intérieur de l'entrefer 3a, cet élément étant monté sur une plaque de support 2 comportant en outre un circuit électrique 6, non-représenté en détail sur ces figures, destiné notamment à amplifier le signal de sortie de l'élément détecteur de champ magnétique 5. Le conducteur formant l'enroulement 4 présente deux portions d'extrémité 4b qui dépassent un bord de la plaque de support 2 et permettent la connexion de cet enroulement à un circuit extérieur, par exemple par soudure sur une plaque de circuit imprimé. Le circuit électrique 6 présente des bornes de connexion 8 qui dépassent également le bord de la plaque de support 2 de façon à pouvoir être connectées à un circuit extérieur de façon similaire aux extrémités de conducteur 4b.

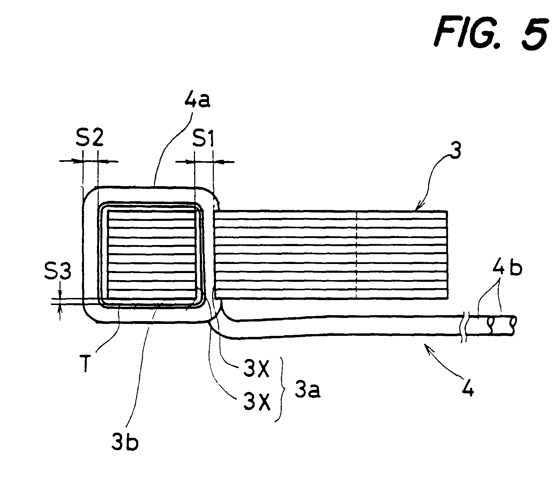

Le schéma de la Fig. 4 montre le principe de fonctionnement du présent capteur, le courant à mesurer circulant dans l'enroulement 4 étant indiqué par Iₚ. Ce courant produit un champ magnétique H qui est mesuré par l'élément détecteur de champ magnétique 5 connecté au circuit électrique 6. L'élément 5, tel que représenté à la Fig. 4, par exemple une cellule de Hall, comporte quatre bornes dont une première est connectée à un circuit non-représenté, d'un type connu, fournissant un courant constant. A la borne 5b apparaît le signal de sortie de l'élément détecteur, les bornes 5c et 5d étant connectées à un amplificateur opérationnel 6b qui maintient le potentiel de la borne 5d à zéro, soit au potentiel de la masse du circuit (borne GND). La borne 5b est connectée à un amplificateur 6c et qui fournit à la borne de sortie OUT un signal de mesure représentatif du courant dans l'enroulement 4. Les deux autres bornes extérieures 8 sont des bornes d'alimentation +15 V et -15 V.

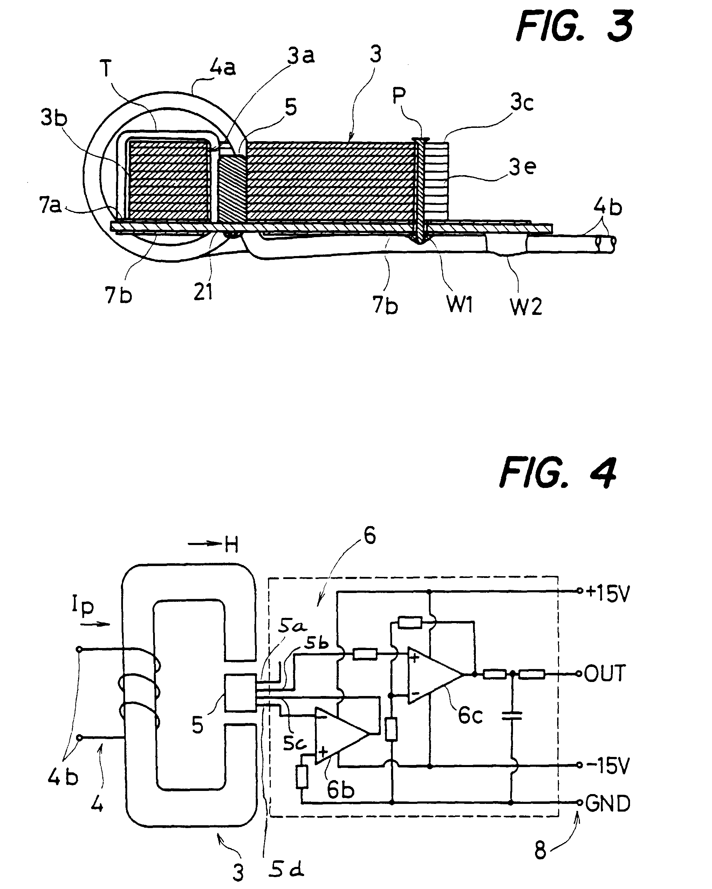

Les Figs 1 et 2 ainsi que la Fig. 3 montrent la plaque de support 2 qui comporte une partie principale 21 ainsi qu'un prolongement latéral 23, l'ensemble présentant une zone découpée 22 par rapport à la forme générale rectangulaire de la plaque. Les spires 4a de l'enroulement 4 sont disposés à l'endroit de cette zone découpée, de sorte que l'épaisseur du présent capteur est déterminée par les dimensions transversales de cet enroulement qui peut être cylindrique, comme montré à la Fig. 3, ou épouser plus étroitement le circuit magnétique 3 selon la forme d'exécution de la Fig. 5 correspondant essentiellement à celle des Figs 1 et 2.

Le circuit magnétique 3 est réalisé sous forme d'un empilement de tôles magnétiquement perméables et comporte une branche pratiquement rectiligne sur laquelle sont disposés un tube isolant T et les spires 4a de l'enroulement 4. Le tube T est de préférence réalisé en un matériau thermo-rétrécissable de façon à enserrer la branche rectiligne du circuit et à maintenir ainsi ensemble les tôles à cet endroit, en plus de sa fonction d'isolation électrique. L'enroulement 4 est préformé avant d'être installé sur la branche rectiligne du circuit magnétique en passant par l'entrefer de ce circuit.

Le circuit magnétique 3 est fixé sur la plaque de support 2 par des goupilles P qui sont insérées de force dans des encoches 3e de la partie 3c du circuit opposée à la branche rectiligne portant l'enroulement 4. Ces goupilles P ont, à une extrémité, une tête élargie et traversent tout le paquet de tôles ainsi que la plaque de support. Au moins l'une est connectée par soudure en W1 sur une partie métallisée 7b d'une face de la plaque de support. Sur la face opposée de cette plaque sur laquelle s'applique une partie du circuit magnétique 3, une zone métallisée 7a est en contact électrique avec le circuit magnétique 3.

L'élément détecteur de champ magnétique 5 est disposé dans l'entrefer du circuit magnétique 3 et est connecté au circuit électrique 6 du côté B de la plaque opposé au côté F sur lequel est fixé le circuit magnétique 3. Les zones métallisées 7a et 7b sont reliées à la borne de sortie 8 représentant la masse et constituent des zones de blindage de part et d'autre de la plaque de support, en s'étendant notamment entre l'enroulement 4 et l'élément détecteur de champ magnétique 5. Une forme préférentielle de ces zones est montrée aux Figs 1 et 2, le reste du circuit imprimé formant le circuit 6 n'étant indiqué que partiellement. La référence 6a désigne des composants de ce circuit, représentés schématiquement. Les conducteurs 4b sont disposés de façon à passer sur le côté B de la plaque de support et sont fixés par des soudures W2 aux endroits 23a du prolongement 23 de la plaque de support.

La Fig. 5 montre une forme d'exécution de l'enroulement 4 qui permet non seulement de réduire l'épaisseur extérieure du capteur par rapport à la forme d'exécution de la Fig. 3, mais également de réduire la longueur de l'entrefer 3a (entre 3X, 3X) tout en permettant le montage de l'enroulement sur la branche rectiligne en le faisant passer par l'entrefer. En effet, la section rectangulaire de l'enroulement de la Fig. 5 ne nécessite qu'un entrefer S1 légèrement plus grand que l'épaisseur S2 de l'enroulement, tel que cela est illustré par la Fig.5 dans laquelle l'épaisseur du tube T est désignée par S3.

Il ressort de ce qui précède que le présent capteur peut être réalisé sous une forme extrêmement plate, son épaisseur étant déterminée essentiellement par l'épaisseur du circuit magnétique et de l'enroulement dans lequel passe le courant à mesurer. D'autre part, ce capteur se distingue par une faible interférence entre le circuit du courant à mesurer et l'élément détecteur de champ magnétique avec son circuit d'amplification, ainsi qu'une bonne immunité contre des champs de fuite engendrés par l'environnement du capteur, notamment du fait de la présence desdites zones métallisées formant un blindage efficace des deux côtés de la plaque de support. Enfin, le présent capteur permet une fabrication économique et rationnelle, du fait notamment que l'enroulement peut être préformé et mis en place simplement par un mouvement de translation à travers l'entrefer, que le circuit magnétique peut ainsi être réalisé en une seule pièce en un matériau approprié, par exemple en ferrite, ou par des tôles de même forme et que ce circuit est fixé très simplement d'un côté de la plaque de support du capteur, et que les soudures peuvent être faites d'un seul côté de cette plaque de support. La forme plate du capteur permet en particulier son montage sur une plaque de circuit extérieure de façon à obtenir un encombrement minimal, que le capteur soit installé dans une position perpendiculaire ou, par un pliage à angle droit des conducteurs de connexion, dans une position parallèle à une telle plaque extérieure.

## Revendications

1. Capteur de courant pour la mesure d'un courant électrique passant dans un conducteur, comportant un circuit magnétique (3) avec un entrefer (3a), un détecteur (5) de champ magnétique disposé dans ledit entrefer (3a) et une plaque de support (2) portant un circuit électrique (6) agencé pour amplifier un signal de sortie dudit détecteur (5) de champ magnétique, cette plaque de support présentant une zone découpée (22), caractérisé en ce que, le circuit magnétique (3) étant réalisé sous forme d'un empilement de tôles et portant un enroulement (4) dans lequel passe le courant électrique à mesurer, un tube (T) électriquement isolant est disposé autour d'une branche de ce circuit magnétique (3) à l'intérieur dudit enroulement (4) de façon à maintenir ensemble à cet endroit les parties des différentes tôles formant ladite branche, et une partie du circuit magnétique (3) est fixée mécaniquement directement sur la plaque de support (2) de façon à maintenir ensemble les tôles du circuit au moyen de cette fixation (P) et de telle façon que ledit enroulement (4) soit disposé au moins partiellement dans ladite zone découpée (22).

2. Capteur selon la revendication 1, caractérisé en ce que la plaque de support comporte au moins une zone métallisée (7a,7b) de blindage, reliée à la masse du circuit électrique, cette zone présentant au moins une partie s'étendant entre le détecteur (5) de champ magnétique et ledit enroulement (4).

3. Capteur selon la revendication 2, caractérisé en ce que ladite zone métallisée (7a,7b) de blindage présente une portion s'étendant entre la plaque de support (2) et une partie du circuit magnétique (3).

4. Capteur selon la revendication 2, caractérisé en ce que chaque côté de la plaque de support (2) comporte au moins une telle zone métallisée (7a,7b) de blindage.

5. Capteur selon la revendication 1, caractérisé en ce que l'enroulement (4) est disposé sur une branche essentiellement rectiligne du circuit magnétique, l'entrefer (3a) étant formé entre une partie de surface latérale d'une extrémité libre de cette branche rectiligne et une extrémité libre d'une branche du circuit magnétique (3) perpendiculaire à ladite branche rectiligne.

6. Capteur selon la revendication 5, caractérisé en ce que l'épaisseur de l'enroulement (4) dans le sens transversal de celui-ci est inférieure à la longueur de l'entrefer (3a) du circuit magnétique (3).

7. Capteur selon la revendication 1, caractérisé en ce que le tube (T) isolant est réalisé en un matériau thermo-rétrécissable.

## Patentansprüche

1. Stromsensor zur Messung eines in einem Leiter fliessenden elektrischen Stroms, der einen magnetischen Kreis (3) mit einem Luftspalt (3a), einen in dem genannten Luftspalt (3a) angeordneten magnetischen Felddetektor (5) und eine Trägerplatte (2) aufweist, die einen elektrischen Kreis (6) trägt, welcher zur Verstärkung eines Ausgangssignals des genannten magnetischen Felddetektors (5) ausgebildet ist, wobei diese Trägerplatte einen ausgeschnittenen Bereich (22) aufweist, dadurch gekennzeichnet, dass der magnetische Kreis in Form eines Stapels von Blechen ausgeführt ist und eine Wicklung (4) trägt, in der der zu messende elektrische Strom fliesst, dass eine elektrisch isolierende Hülse (T) um einen Zweig dieses magnetischen Kreises (3) im Inneren der genannten Wicklung (4) angeordnet ist, derart, dass an dieser Stelle die verschiedenen Blechteile, welche den genannten Zweig bilden, zusammengehalten werden, und dass ein Teil des magnetischen Kreises (3) mechanisch direkt auf der Trägerplatte (2) befestigt ist, so dass die Bleche dieses Kreises mit Hilfe dieser Befestigung (P) zusammengehalten werden, und derart, dass die genannte Wicklung (4) zumindest teilweise in dem genannten ausgeschnittenen Bereich (22) angeordnet ist.

2. Sensor nach Patentanspruch 1, dadurch gekennzeichnet, dass die Trägerplatte mindestens einen metallisierten Abschirmbereich (7a, 7b) aufweist, der mit der Masse des elektrischen Kreises verbunden ist, wobei dieser Bereich mindestens einen Teil aufweist, der sich zwischen dem magnetischen Felddetektor (5) und der genannten Wicklung (4) erstreckt.

3. Sensor nach Patentanspruch 2, dadurch gekennzeichnet, dass der genannte metallisierte Abschirmbereich (7a, 7b) einen Teil aufweist, der sich zwischen der Trägerplatte (2) und einem Teil des magnetischen Kreises (3) erstreckt.

4. Sensor nach Patentanspruch 2, dadurch gekennzeichnet, dass jede Seite der Trägerplatte (2) mindestens einen solchen metallisierten Abschirmbereich (7a, 7b) aufweist.

5. Sensor nach Patentanspruch 1, dadurch gekennzeichnet, dass die Wicklung (4) auf einem im wesentlichen geradlinigen Zweig des magnetischen Kreises angeordnet ist, wobei der Luftspalt (3a) zwischen einem Teil der Seitenfläche eines freien Endes dieses geradlinigen Zweigs und einem freien Ende eines Zweigs des magnetischen Kreises (3), der senkrecht zu dem genannten geradlinigen Zweig liegt, gebildet wird.

6. Sensor nach Patentanspruch 5, dadurch gekennzeichnet, dass die Dicke der Wicklung (4) in Querrichtung derselben kleiner ist als die Länge des Luftspalts (3a) des magnetischen Kreises (3).

7. Sensor nach Patentanspruch 1, dadurch gekennzeichnet, dass die isolierende Hülse (T) aus einem wärmeschrumpfbaren Material hergestellt ist.

## Claims

1. Current sensor for measuring an electric current flowing through a conductor, comprising a magnetic circuit (3) with an air-gap (3a), a magnetic field detector (5) arranged in said air-gap (3a), and a support plate (2) bearing an electric circuit (6) arranged for amplifying an output signal of said magnetic field detector (5), said support plate having a cut-away area (22), characterized in that, the magnetic circuit (3) being in the form of a stack of metal sheets and carrying a winding (4) through which flows the electric current to be measured, an electrically insulating tube (T) is arranged around the arm of the magnetic circuit (3) inside said winding (4) in order to hold the portions of different sheets forming this arm together, and a portion of the magnetic circuit (3) is fixed mechanically directly on the support plate (2) such that the sheets of the circuit are held together by this attachment (P) and such that said winding (4) is arranged at least partially in said cut-away area (22).

2. Sensor according to claim 1, characterized in that the support plate comprises at least one metallized shielding area (7a, 7b) which is connected to the ground of the electric circuit, this area having at least one portion extending between the magnetic field detector (5) and said winding (4).

3. Sensor according to claim 2, characterized in that said metallized shielding area (7a, 7b) has a portion extending between the support plate (2) and part of the magnetic circuit (3).

4. Sensor according to claim 2, characterized in that each side of the support plate (2) comprises at least one such metallized shielding area (7a, 7b).

5. Sensor according to claim 1, characterized in that the winding (4) is placed on a substantially rectilinear arm of the magnetic circuit, the air-gap (3a) being formed between a lateral surface portion of a free end of this rectilinear arm and a free end of an arm of the magnetic circuit (3) perpendicular to said rectilinear arm.

6. Sensor according to claim 5, characterized in that the thickness of the winding (4) in the transverse direction thereof is smaller than the length of the air-gap (3a) of the magnetic circuit (3).

7. Sensor according to claim 5, characterized in that the electrically insulating tube (T) is made of a heat-shrinkable material.
